# EUROPEAN PATENT APPLICATION

(11) **EP 4 696 542 A1**
(43) Date of publication of application: **18.02.2026**
(21) Application number: 25192137.5
(22) Date of filing: 28.07.2025
(51) Int. Cl.: B60L 53/10, B60L 53/14, B60L 53/302, H01R 13/00, H02G 3/03

(54) **FLUID ADAPTER MODULE AND ELECTRICAL CONNECTION PRODUCT**

(30) Priority: 31.07.2024 CN 202411047360
(71) Applicant: Tyco Electronics (Shanghai) Co., Ltd., Pilot Free Trade Zone Shanghai 200131 (CN); Tyco Electronics Technology (SIP) Co., Ltd., Suzhou 215126 (CN)
(72) Inventor: Xia, Leilei, Shanghai, 200233 (CN); Zhu, Fangyue, Shanghai, 200233 (CN); Zhang, Qun, Suzhou, 32 215123 (CN); Zhang, Jiachen, Suzhou, 32 215123 (CN); Zhang, Haibo, Shanghai, 200233 (CN)
(74) Representative: Grünecker Patent- und Rechtsanwälte PartG mbB

(57) **Abstract**

The present invention discloses a fluid adapter module and an electrical connection product. The fluid adapter module comprises a housing. The housing comprises: a housing body defining an inner cavity for accommodating a cooling fluid; a first mating connector formed on an outer side of the housing body and connected with the inner cavity; and a second mating connector formed on the outer side of the housing body and connected with the inner cavity. The first mating connector is configured for mating connection with a pipe connector on an insulating cap of a power transmission member and the second mating connector is configured for mating connection with a connecting pipe of a cooling circuit, such that a cooling passage in the power transmission member is capable of being connected to the cooling circuit via the fluid adapter module. In the present invention, the fluid adapter module can easily and quickly connect the cooling passage of the power transmission member to the cooling circuit, making it very easy to use.

## Description

### CROSS-REFERENCE TO RELATED APPLICATION

This application claims the benefit of Chinese Patent Application No. CN 202411047360.7 filed on July 31, 2024 in the State Intellectual Property Office of China, the whole disclosure of which is incorporated herein by reference.

### BACKGROUND OF THE INVENTION

### Field of the Invention

The present invention relates to a fluid adapter module and an electrical connection product comprising the fluid adapter module.

### Description of the Related Art

In the prior art, with the increasingly high charging current of electric vehicles, the vehicle charging current now is required to be 600 A, and is expected to rise to 1000 A in the future. This leads to an increasing temperature rise of a power transmission member (e.g., a wire) connected to a charging dock or a charging gun. In order to reduce the temperature rise of the power transmission member, the charging dock and the charging gun, it is necessary to employ a large-cross-section power transmission member, such as a large-cross-section copper or aluminum wire, but this will result in a large size and high costs.

### SUMMARY OF THE INVENTION

The present invention has been made to overcome or alleviate at least one aspect of the above mentioned disadvantages.

According to an aspect of the present invention, there is provided a fluid adapter module. The fluid adapter module comprises a housing. The housing comprises: a housing body defining an inner cavity for accommodating a cooling fluid; a first mating connector formed on an outer side of the housing body and connected with the inner cavity; and a second mating connector formed on the outer side of the housing body and connected with the inner cavity. The first mating connector is configured for mating connection with a pipe connector on an insulating cap of a power transmission member and the second mating connector is configured for mating connection with a connecting pipe of a cooling circuit, such that a cooling passage in the power transmission member is capable of being connected to the cooling circuit via the fluid adapter module.

According to an exemplary embodiment of the present invention, the housing body is configured to define two inner cavities spaced apart from each other, the housing comprises two first mating connectors connected with the two inner cavities, respectively, and the two first mating connectors are configured for respectively mating connection with two pipe connectors on the insulating cap of the power transmission member.

According to another exemplary embodiment of the present invention, the housing comprises two second mating connectors connected with the two inner cavities, respectively, and the two second mating connectors is configured for mating connection with two connecting pipes of the cooling circuit, respectively.

According to another exemplary embodiment of the present invention, the first mating connector has a first insertion hole for insertion of the pipe connector, the second mating connector has a second insertion hole for insertion of the connecting pipe, and the first insertion hole and the second insertion hole are connected with the inner cavity.

According to another exemplary embodiment of the present invention, the first mating connector is formed on an outer side of a rear wall of the housing body, the second mating connector is formed on a bottom wall of the housing body, and the housing body has a front opening opposite the rear wall of the housing body. The housing further comprises: a front cover mounted on the front opening of the housing body to close the front opening of the housing body.

According to another exemplary embodiment of the present invention, the fluid adapter module further comprises: a screw passing through the front cover and being threadedly connected to a front side of the housing body to secure the front cover to the front side of the housing body; and a sealing ring squeezed between the front cover and the housing body to achieve sealing between the front cover and the housing body.

According to another exemplary embodiment of the present invention, the fluid adapter module further comprises: a locking member inserted and mounted in the first mating connector and configured to lock the pipe connector in the first mating connector. The locking member is movable between a locking position in which the locking member is engaged with the pipe connector and an unlocking position in which the locking member is disengaged from the pipe connector in an axial direction of the first mating connector.

According to another exemplary embodiment of the present invention, the fluid adapter module further comprises: an unlocking member mounted on the housing body and movable in a radial direction of the first mating connector. An inclined surface axially inclined to the first mating connector is formed on the unlocking member, and the inclined surface is configured to convert a radial movement of the unlocking member into an axial movement of the locking member, to enable the locking member to be axially pushed from the locking position to the unlocking position by the unlocking member.

According to another exemplary embodiment of the present invention, the unlocking member is movable between a first position and a second position in the radial direction of the first mating connector. When the unlocking member is moved to the first position, the unlocking member axially pushes the locking member to the unlocking position by means of the inclined surface on the unlocking member. When the unlocking member is moved to the second position, the unlocking member is disengaged from the locking member, and the locking member is elastically reset to the locking position automatically.

According to another exemplary embodiment of the present invention, the housing body has a mounting portion located on the outer side of the housing body, the mounting portion has a bottom plate and a pair of side plates, the first mating connector is located in the mounting portion, and the unlocking member is movably mounted on the mounting portion and is movable between the first position and the second position in a vertical direction.

According to another exemplary embodiment of the present invention, insertion slots extending in the vertical direction are formed in inner sides of the pair of side plates of the mounting portion, and two sides of the unlocking member are respectively inserted and mounted into the insertion slots of the pair of side plates and the unlocking member is movable between the first position and the second position along the insertion slots.

According to another exemplary embodiment of the present invention, a slot hole is formed in the bottom plate of the mounting portion, the unlocking member has an elastic latch configured to pass through the slot hole, and a first protruding rib and a second protruding rib below the first protruding rib are formed on the elastic latch. When the unlocking member is moved to the first position, the first protruding rib abuts against a lower edge portion of the slot hole to retain the unlocking member in the first position. When the unlocking member is moved to the second position, the second protruding rib abuts against an upper edge portion of the slot hole to retain the unlocking member in the second position.

According to another exemplary embodiment of the present invention, an annular engagement groove is formed in an outer circumferential surface of an end portion of the first mating connector, and the unlocking member further has an arc-shaped plate located above the annular engagement groove. When the unlocking member is moved to the first position, the arc-shaped plate of the unlocking member is inserted into the annular engagement groove to prevent the unlocking member from moving in the axial direction of the first mating connector, such that the unlocking member is reliably retained in the first position.

According to another exemplary embodiment of the present invention, when the unlocking member is moved to a pre-assembly position between the first position and the second position, the first protruding rib abuts against the upper edge portion of the slot hole to retain the unlocking member in the pre-assembly position. When the unlocking member is in the pre-assembly position, the unlocking member does not interfere with the locking member and the pipe connector to allow the pipe connector to be inserted into the first mating connector.

According to another exemplary embodiment of the present invention, the housing comprises a plurality of first mating connectors configured for mating connection with a plurality of pipe connectors, respectively, the fluid adapter module comprises a plurality of locking members mounted in the plurality of first mating connectors, respectively, and the unlocking member is capable of simultaneously pushing the plurality of locking members axially from the locking position to the unlocking position.

According to another exemplary embodiment of the present invention, the first mating connector is same as the second mating connector, such that either of the first mating connector and the second mating connector is capable of being in mating connection not only with the pipe connector but also with the connecting pipe.

According to another aspect of the present invention, there is provided an electrical connection product. The electrical connection product comprises: a power transmission member comprising an insulating body and a first metal busbar and a second metal busbar wrapped in the insulating body, a cooling passage being formed in the insulating body; an insulating cap assembly comprising an insulating cap sealingly sleeved on an end portion of the power transmission member, a pipe connector being formed on the insulating cap; and the aforementioned fluid adapter module, a first mating connector of the fluid adapter module being in mating connection with the pipe connector, wherein a second mating connector of the fluid adapter module is configured for mating connection with a connecting pipe of a cooling circuit to allow a cooling fluid to flow between the cooling passage of the power transmission member and the cooling circuit via the fluid adapter module.

According to an exemplary embodiment of the present invention, two cooling passages are formed in the insulating body, and the insulating body has an intermediate partition wall for separating the two cooling passages. The two cooling passages are respectively adjacent to the first metal busbar and the second metal busbar, to enable the first metal busbar and the second metal busbar to be cooled respectively by the cooling fluid flowing through the two cooling passages.

According to another exemplary embodiment of the present invention, the insulating body has isolation walls for isolating the cooling passages from the first metal busbar and the second metal busbar, to enable the cooling fluid flowing through the cooling passages not to be in physical contact with the first metal busbar and the second metal busbar.

According to another exemplary embodiment of the present invention, the insulating body is an injection-molded member formed directly on the first metal busbar and the second metal busbar by means of an insert injection molding process, such that the first metal busbar, the second metal busbar and the insulating body are formed to be an integral part.

According to another exemplary embodiment of the present invention, the insulating cap comprises: a peripheral wall sleeved on the end portion of the power transmission member; and an end wall connected to the peripheral wall. The pipe connector is formed on the end wall, a threaded hole is formed in an end surface of the insulating body, and a connecting hole corresponding to the threaded hole is formed in the end wall. The insulating cap assembly further comprises a threaded member configured to pass through the connecting hole and be threadedly connected to the threaded hole to secure the insulating cap to the end portion of the power transmission member.

According to another exemplary embodiment of the present invention, the insulating cap assembly further comprises: a sealing member comprising an annular body squeezed between the end wall of the insulating cap and an end surface of the power transmission member to achieve sealing between the insulating cap and the power transmission member. The connecting hole and the threaded hole are located outside a region surrounded by the annular body of the sealing member, and the pipe connector and end openings of the cooling passage of the power transmission member are located inside the region surrounded by the annular body of the sealing member.

According to another exemplary embodiment of the present invention, the first metal busbar and the second metal busbar each have a top surface and a bottom surface opposite each other in a thickness direction thereof and two side surfaces opposite each other in a width direction thereof. The first metal busbar and the second metal busbar are arranged side by side and spaced oppositely in the width direction thereof, and the cooling passages are located between the side surface of the first metal busbar and the side surface of the second metal busbar.

According to another exemplary embodiment of the present invention, the insulating cap has two pipe connectors, and the two pipe connectors are connected with the two cooling passages of the power transmission member respectively and are connected to two first mating connectors of the fluid adapter module respectively, to enable the cooling fluid to flow into and out of the two cooling passages respectively through the two pipe connectors.

According to another exemplary embodiment of the present invention, the insulating cap further has a partition rib formed on an inner side of the end wall, and the sealing member further has an isolation rib located in the annular body and connected to the annular body. The isolation rib of the sealing member is squeezed between the partition rib of the insulating cap and an end surface of the intermediate partition wall of the insulating body, to isolate end openings of the two fluid passages from each other and isolate the two pipe connectors from each other.

According to another exemplary embodiment of the present invention, the electrical connection product further comprises: a housing; and a first terminal and a second terminal inserted and mounted into the housing. The first metal busbar and the second metal busbar are electrically connected to the first terminal and the second terminal, respectively. The insulating cap is inserted and mounted into the housing, and the pipe connector of the insulating cap is exposed from the housing for mating connection with the first mating connector.

According to another exemplary embodiment of the present invention, the insulating cap assembly further comprises: an outer sealing ring sleeved on the insulating cap. The outer sealing ring is squeezed radially between the insulating cap and the housing to achieve sealing between the insulating cap and the housing.

In the aforementioned exemplary embodiments according to the present invention, the fluid adapter module can easily and quickly connect the cooling passage of the power transmission member to the cooling circuit, making it very easy to use.

In some of the aforementioned exemplary embodiments according to the present invention, the power transmission member has the cooling passage located between the first metal busbar and the second metal busbar, such that the first metal busbar and the second metal busbar can be fully cooled by the cooling fluid flowing through the cooling passage. The cooling passage of the present invention has a large cooling area and a high cooling efficiency, can effectively reduce the temperature rise of the power transmission member without increasing the cross-sectional area of the metal busbars.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative exploded view of an electrical connection product according to an exemplary embodiment of the present invention;
Figure 2 shows an illustrative assembled view of an electrical connection product according to an exemplary embodiment of the present invention;
Figure 3 shows an illustrative exploded view of a fluid adapter module and an insulating cap according to an exemplary embodiment of the present invention;
Figure 4 shows an illustrative perspective view of a fluid adapter module according to an exemplary embodiment of the present invention;
Figure 5 shows an exploded sectional view of a fluid adapter module and an insulating cap according to an exemplary embodiment of the present invention;
Figure 6 shows a horizontal sectional view of a fluid adapter module and an insulating cap according to an exemplary embodiment of the present invention;
Figure 7 shows a vertical sectional view of a fluid adapter module according to an exemplary embodiment of the present invention;
Figure 8 shows an illustrative exploded view of a fluid adapter module according to an exemplary embodiment of the present invention;
Figure 9 shows a plan sectional view of a fluid adapter module according to an exemplary embodiment of the present invention, with an unlocking member in a first position;
Figure 10 shows a plan sectional view of a fluid adapter module according to an exemplary embodiment of the present invention, with an unlocking member in a second position;
Figure 11 shows a plan sectional view of a fluid adapter module according to an exemplary embodiment of the present invention, with an unlocking member in a pre-assembly position;
Figure 12 shows an illustrative perspective view of an electrical connection product according to another exemplary embodiment of the present invention, with a fluid adapter module not shown;
Figure 13 shows an illustrative exploded view of the electrical connection product shown in Figure 12;
Figure 14 shows an illustrative assembled view of a power transmission member, a first terminal and a second terminal of the electrical connection product shown in Figure 12;
Figure 15 shows an illustrative exploded view of the power transmission member, the first terminal and the second terminal of the electrical connection product shown in Figure 12;
Figure 16 shows an illustrative perspective view of the power transmission member and an insulating cap assembly of the electrical connection product shown in Figure 12;
Figure 17 shows a sectional view of the power transmission member and the insulating cap assembly of the electrical connection product shown in Figure 16;
Figure 18 shows an illustrative exploded view of the power transmission member and the insulating cap assembly of the electrical connection product shown in Figure 16; and
Figure 19 shows an exploded sectional view of the power transmission member and the insulating cap assembly of the electrical connection product shown in Figure 16.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a fluid adapter module. The fluid adapter module comprises a housing. The housing comprises: a housing body defining an inner cavity for accommodating a cooling fluid; a first mating connector formed on an outer side of the housing body and connected with the inner cavity; and a second mating connector formed on the outer side of the housing body and connected with the inner cavity. The first mating connector is configured for mating connection with a pipe connector on an insulating cap of a power transmission member and the second mating connector is configured for mating connection with a connecting pipe of a cooling circuit, such that a cooling passage in the power transmission member is capable of being connected to the cooling circuit via the fluid adapter module.

According to another general concept of the present invention, there is provided an electrical connection product. The electrical connection product comprises: a power transmission member comprising an insulating body and a first metal busbar and a second metal busbar wrapped in the insulating body, a cooling passage being formed in the insulating body; an insulating cap assembly comprising an insulating cap sealingly sleeved on an end portion of the power transmission member, a pipe connector being formed on the insulating cap; and the aforementioned fluid adapter module, a first mating connector of the fluid adapter module being in mating connection with the pipe connector, wherein a second mating connector of the fluid adapter module is configured for mating connection with a connecting pipe of a cooling circuit to allow a cooling fluid to flow between the cooling passage of the power transmission member and the cooling circuit via the fluid adapter module.

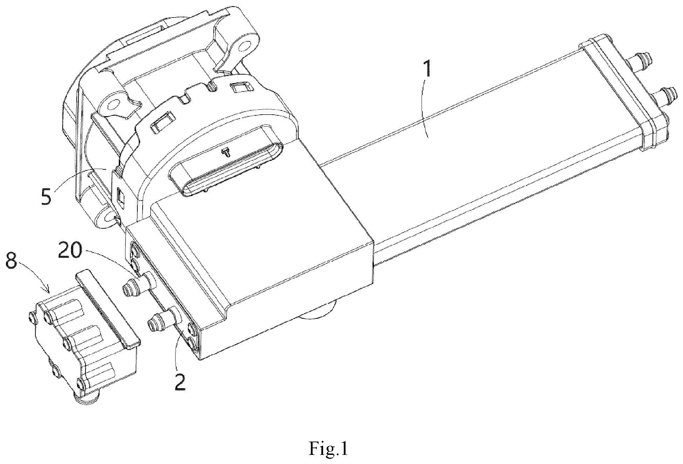

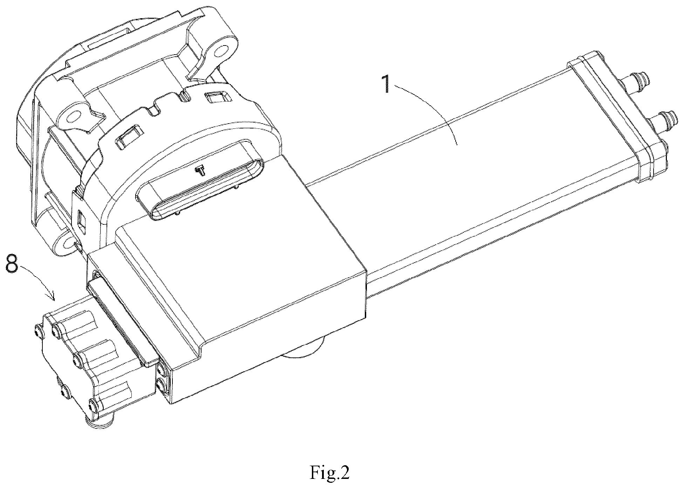

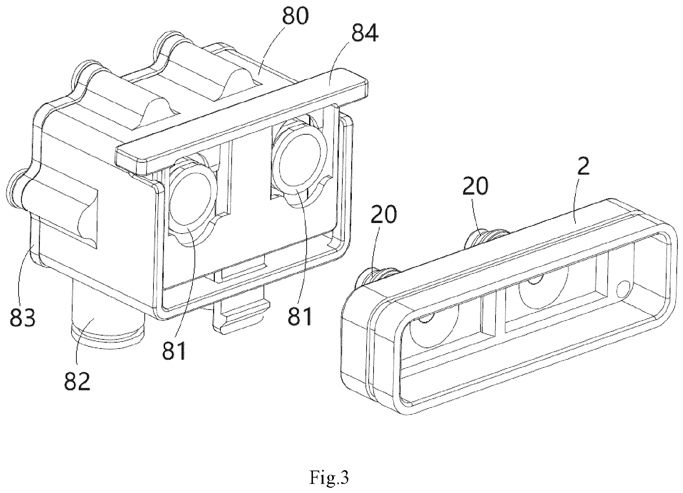

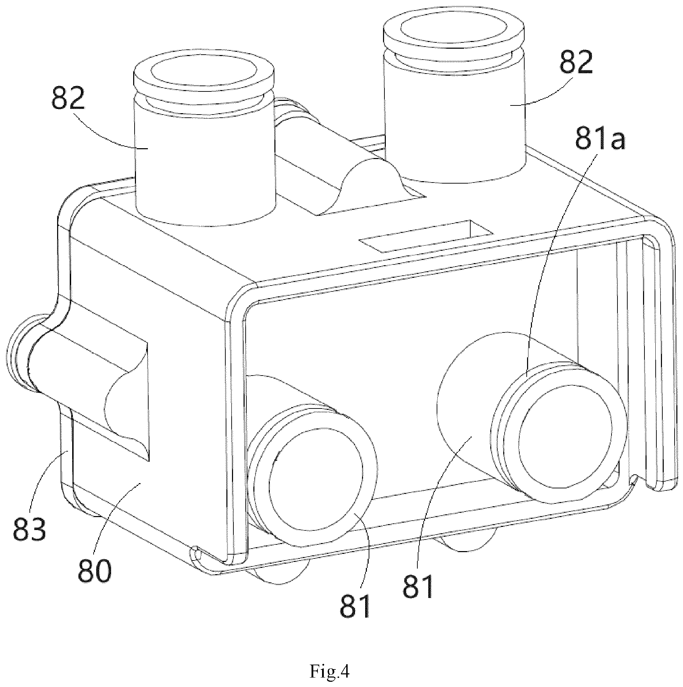

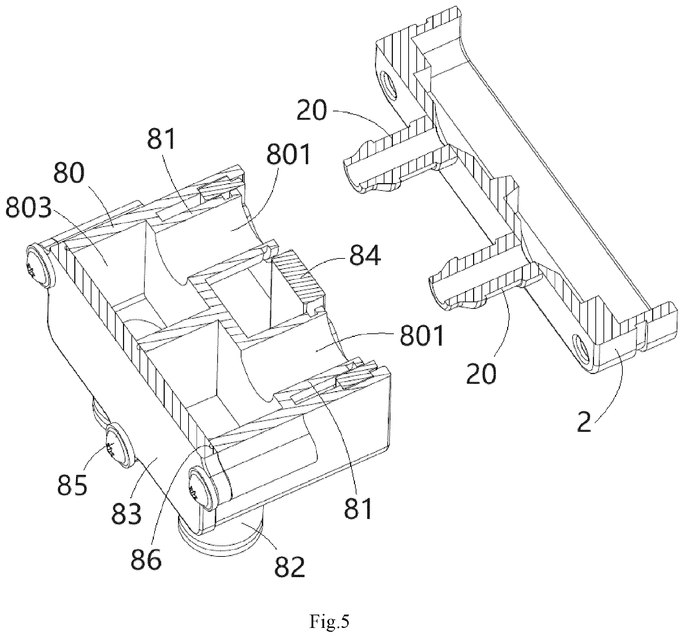

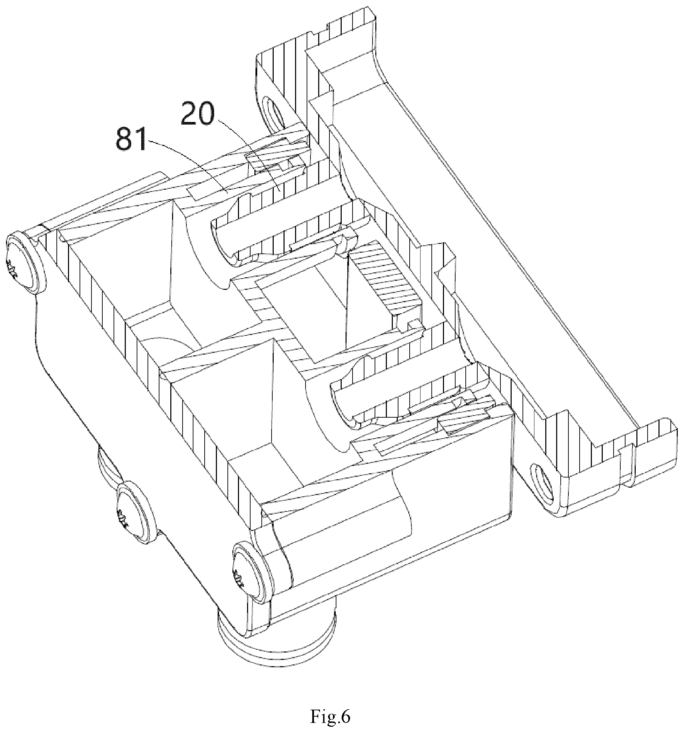

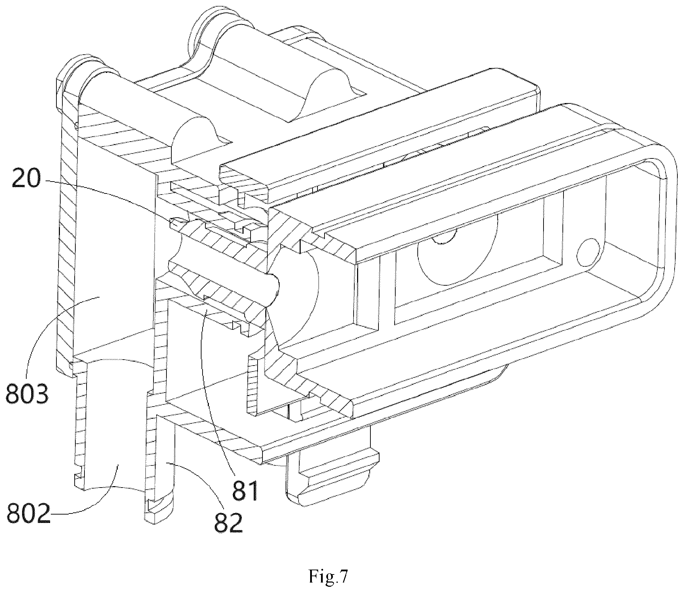

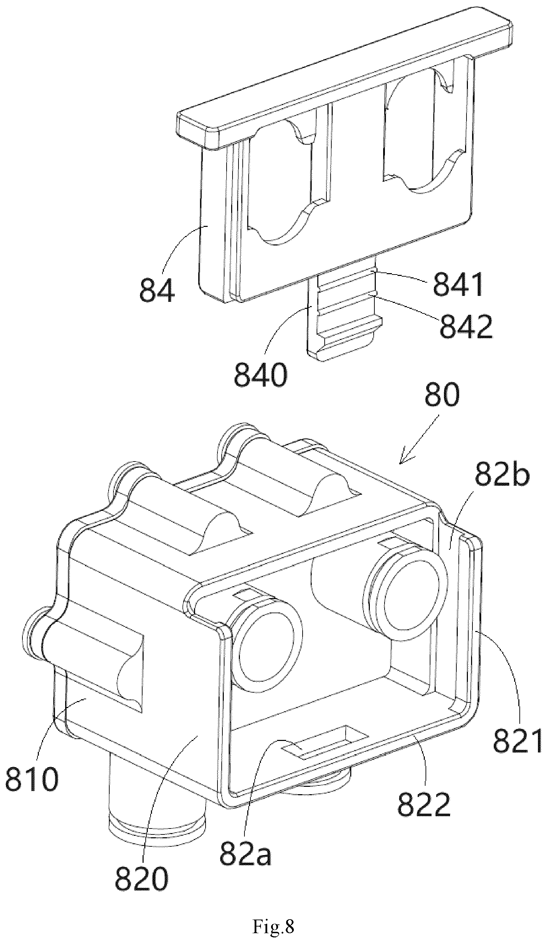

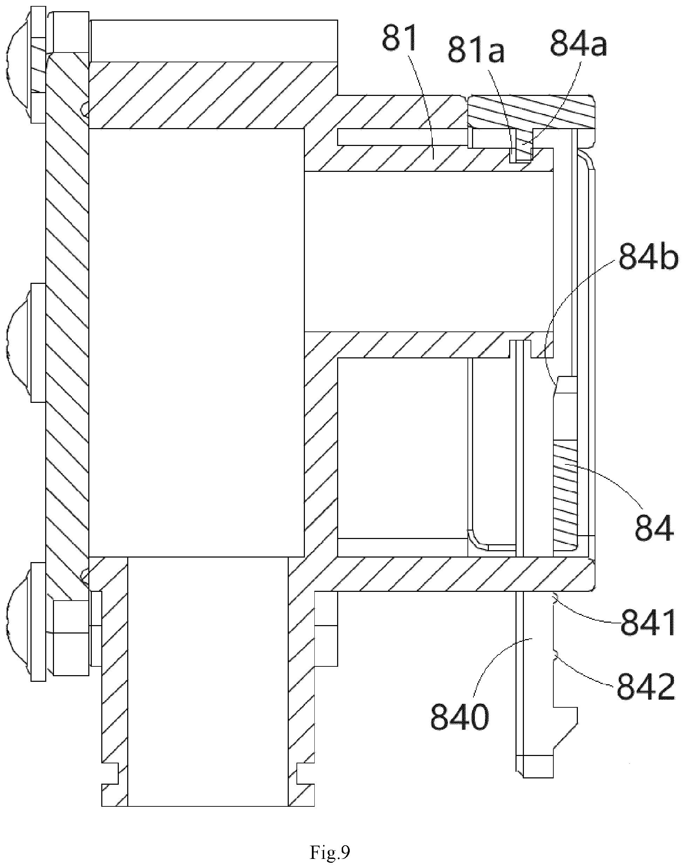

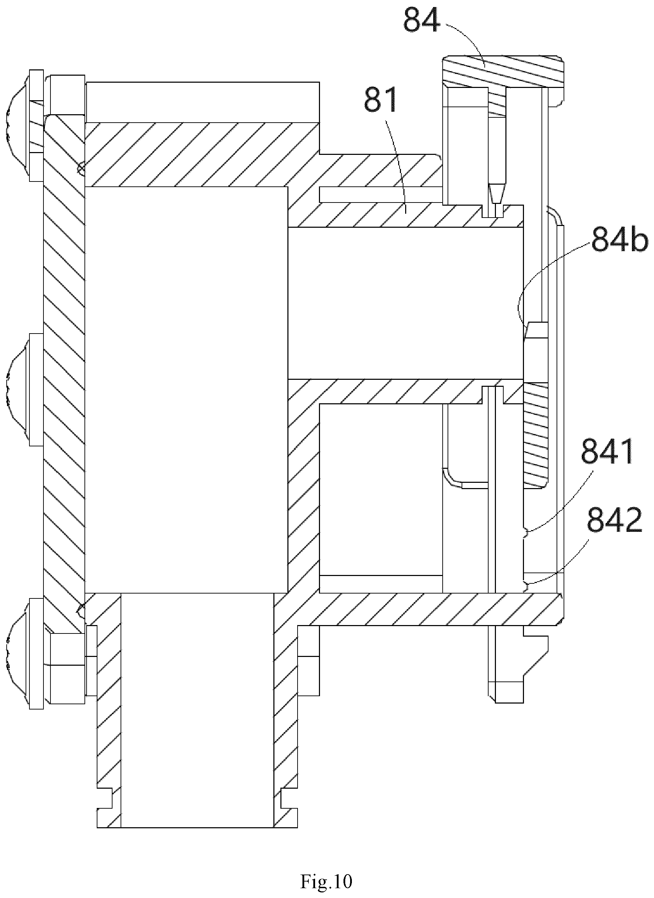

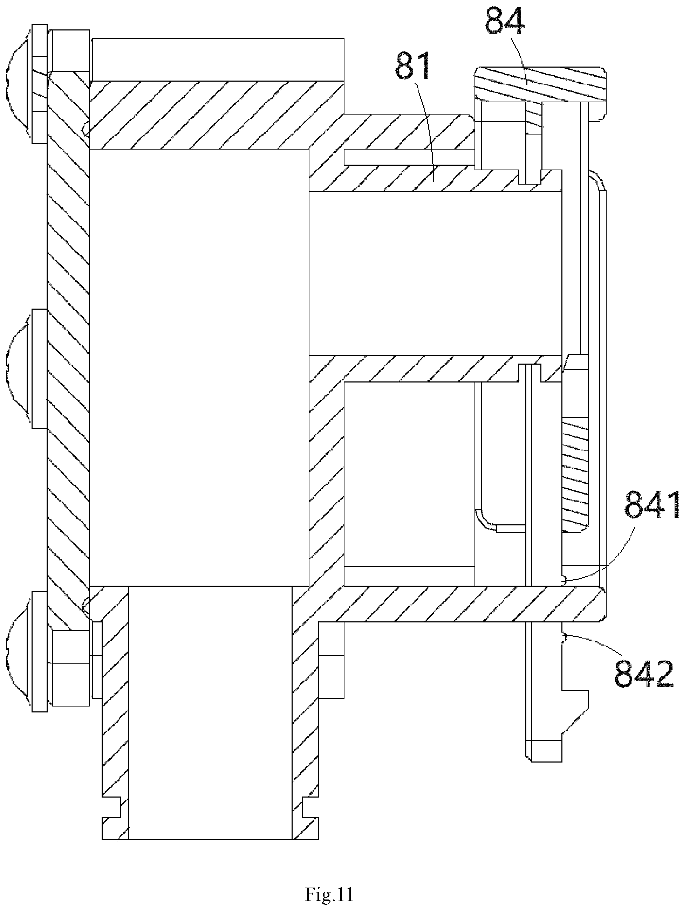

Figure 1 shows an illustrative exploded view of an electrical connection product according to an exemplary embodiment of the present invention; Figure 2 shows an illustrative assembled view of an electrical connection product according to an exemplary embodiment of the present invention; Figure 3 shows an illustrative exploded view of a fluid adapter module 8 and an insulating cap 2 according to an exemplary embodiment of the present invention; Figure 4 shows an illustrative perspective view of a fluid adapter module 8 according to an exemplary embodiment of the present invention; Figure 5 shows an exploded sectional view of a fluid adapter module 8 and an insulating cap 2 according to an exemplary embodiment of the present invention; Figure 6 shows a horizontal sectional view of a fluid adapter module 8 and an insulating cap 2 according to an exemplary embodiment of the present invention; Figure 7 shows a vertical sectional view of a fluid adapter module 8 according to an exemplary embodiment of the present invention; Figure 8 shows an illustrative exploded view of a fluid adapter module 8 according to an exemplary embodiment of the present invention; Figure 9 shows a plan sectional view of a fluid adapter module 8 according to an exemplary embodiment of the present invention, with an unlocking member 84 in a first position; Figure 10 shows a plan sectional view of a fluid adapter module 8 according to an exemplary embodiment of the present invention, with an unlocking member 84 in a second position; Figure 11 shows a plan sectional view of a fluid adapter module 8 according to an exemplary embodiment of the present invention, with an unlocking member 84 in a pre-assembly position.

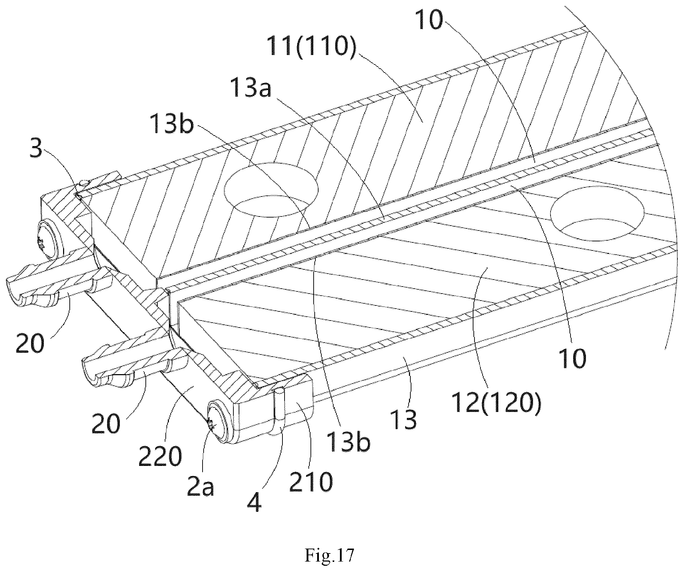

As shown in Figures 1 to 11, in an exemplary embodiment of the present invention, a fluid adapter module 8 is disclosed. The fluid adapter module 8 comprises a housing 80. The housing 80 comprises: a housing body 810, a first mating connector 81 and a second mating connector 82. The housing body 810 defines an inner cavity 803 for accommodating a cooling fluid. The first mating connector 81 is formed on an outer side of the housing body 810 and is connected with the inner cavity 803. The second mating connector 82 is formed on the outer side of the housing body 810 and is connected with the inner cavity 803. The first mating connector 81 is configured for mating connection with a pipe connector 20 on an insulating cap 2 of a power transmission member 1 and the second mating connector 82 is configured for mating connection with a connecting pipe (not shown) of a cooling circuit (not shown), such that a cooling passage 10 (see Figure 17) in the power transmission member 1 is capable of being connected to the cooling circuit via the fluid adapter module 8.

As shown in Figures 1 to 11, in the illustrated embodiment, the housing body 810 defines two inner cavities 803 spaced apart from each other, the housing 80 comprises two first mating connectors 81 connected with the two inner cavities 803, respectively, and the two first mating connectors 81 are configured for respectively mating connection with two pipe connectors 20 on the insulating cap 2 of the power transmission member 1.

As shown in Figures 1 to 11, in the illustrated embodiment, the housing 80 comprises two second mating connectors 82 connected with the two inner cavities 803, respectively, and the two second mating connectors 82 are configured for mating connection with two connecting pipes of the cooling circuit, respectively.

As shown in Figures 1 to 11, in the illustrated embodiment, the first mating connector 81 has a first insertion hole 801 for insertion of the pipe connector 20, the second mating connector 82 has a second insertion hole 802 for insertion of the connecting pipe, and the first insertion hole 801 and the second insertion hole 802 are connected with the inner cavity 803.

As shown in Figures 1 to 11, in the illustrated embodiment, the first mating connector 81 is formed on an outer side of a rear wall of the housing body 810, the second mating connector 82 is formed on a bottom wall of the housing body 810, and the housing body 810 has a front opening opposite the rear wall of the housing body. The housing 80 further comprises a front cover 83 mounted on the front opening of the housing body 810 to close the front opening of the housing body 810.

As shown in Figures 1 to 11, in the illustrated embodiment, the fluid adapter module 8 further comprises: a screw 85 and a sealing ring 86. The screw 85 passes through the front cover 83 and is threadedly connected to a front side of the housing body 810 to secure the front cover 83 to the front side of the housing body 810. The sealing ring 86 is squeezed between the front cover 83 and the housing body 810 to achieve sealing between the front cover and the housing body.

As shown in Figures 1 to 11, in the illustrated embodiment, the fluid adapter module 8 further comprises a locking member (not shown) inserted and mounted in the first mating connector 81 and configured to lock the pipe connector 20 in the first mating connector 81. The locking member is movable between a locking position in which the locking member is engaged with the pipe connector 20 and an unlocking position in which the locking member is disengaged from the pipe connector 20 in an axial direction of the first mating connector 81. The aforementioned locking member may be any one suitable locking member from the prior art, and thus may refer to a locking member in the prior art. For the sake of brevity, this description will not further describe the locking member in detail.

As shown in Figures 1 to 11, in the illustrated embodiment, the fluid adapter module 8 further comprises an unlocking member 84 mounted on the housing body 810 and movable in a radial direction of the first mating connector 81. An inclined surface 84b axially inclined to the first mating connector 81 is formed on the unlocking member 84, and the inclined surface 84b is configured to convert a radial movement of the unlocking member 84 into an axial movement of the locking member, to enable the locking member to be axially pushed from the locking position to the unlocking position by the unlocking member 84.

As shown in Figures 1 to 11, in the illustrated embodiment, the unlocking member 84 is movable between a first position (the position shown in Figure 9) and a second position (the position shown in Figure 10) in the radial direction of the first mating connector 81. When the unlocking member 84 is moved to the first position, the unlocking member 84 axially pushes the locking member to the unlocking position by means of the inclined surface 84b on the unlocking member. When the unlocking member 84 is moved to the second position, the unlocking member 84 is disengaged from the locking member, and the locking member is elastically reset to the locking position automatically.

As shown in Figures 1 to 11, in the illustrated embodiment, the housing body 810 has a mounting portion 820 located on the outer side of the housing body, the mounting portion 820 has a bottom plate 822 and a pair of side plates 821, the first mating connector 81 is located in the mounting portion 820, and the unlocking member 84 is movably mounted on the mounting portion 820 and is movable between the first position and the second position in a vertical direction.

As shown in Figures 1 to 11, in the illustrated embodiment, insertion slots 82b extending in the vertical direction are formed in inner sides of the pair of side plates 821 of the mounting portion 820, and two sides of the unlocking member 84 are respectively inserted and mounted into the insertion slots 82b of the pair of side plates 821 and the unlocking member 84 is movable between the first position and the second position along the insertion slots 82b.

As shown in Figures 1 to 11, in the illustrated embodiment, a slot hole 82a is formed in the bottom plate 822 of the mounting portion 820, the unlocking member 84 has an elastic latch 840 configured to pass through the slot hole 82a, and a first protruding rib 841 and a second protruding rib 842 below the first protruding rib 841 are formed on the elastic latch 840. When the unlocking member 84 is moved to the first position, the first protruding rib 841 abuts against a lower edge portion of the slot hole 82a to retain the unlocking member 84 in the first position. When the unlocking member 84 is moved to the second position, the second protruding rib 842 abuts against an upper edge portion of the slot hole 82a to retain the unlocking member 84 in the second position.

As shown in Figures 1 to 11, in the illustrated embodiment, an annular engagement groove 81a is formed in an outer circumferential surface of an end portion of the first mating connector 81, and the unlocking member 84 further has an arc-shaped plate 84a located above the annular engagement groove 81a. When the unlocking member 84 is moved to the first position, the arc-shaped plate 84a of the unlocking member 84 is inserted into the annular engagement groove 81a to prevent the unlocking member 84 from moving in the axial direction of the first mating connector 81, such that the unlocking member 84 is reliably retained in the first position.

As shown in Figures 1 to 11, in the illustrated embodiment, when the unlocking member 84 is moved to a pre-assembly position (the position shown in Figure 11) between the first position and the second position, the first protruding rib 841 abuts against the upper edge portion of the slot hole 82a to retain the unlocking member 84 in the pre-assembly position. When the unlocking member 84 is in the pre-assembly position, the unlocking member 84 does not interfere with the locking member and the pipe connector 20 to allow the pipe connector 20 to be inserted into the first mating connector 81.

As shown in Figures 1 to 11, in the illustrated embodiment, the housing 80 comprises a plurality of first mating connectors 81 configured for mating connection with a plurality of pipe connectors 20, respectively. The fluid adapter module 8 comprises a plurality of locking members mounted in the plurality of first mating connectors 81, respectively. The unlocking member 84 is capable of simultaneously pushing the plurality of locking members axially from the locking position to the unlocking position.

As shown in Figures 1 to 11, in the illustrated embodiment, the first mating connector 81 is same as the second mating connector 82, such that either of the first mating connector 81 and the second mating connector 82 is capable of being in mating connection not only with the pipe connector 20 but also with the connecting pipe.

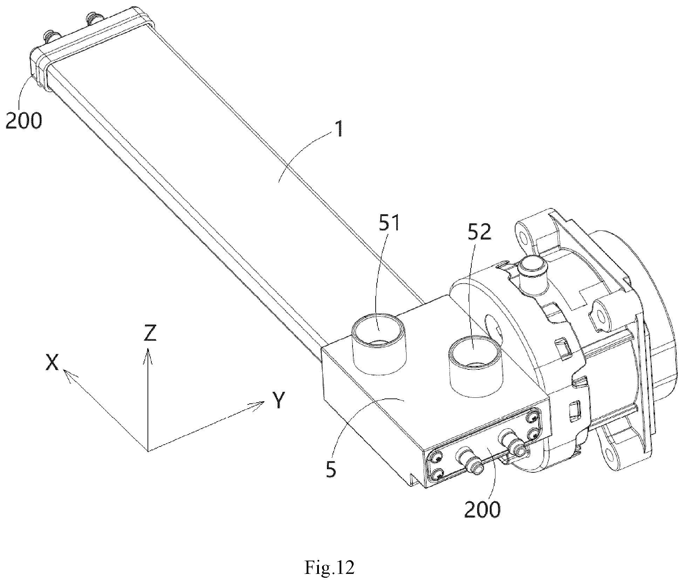

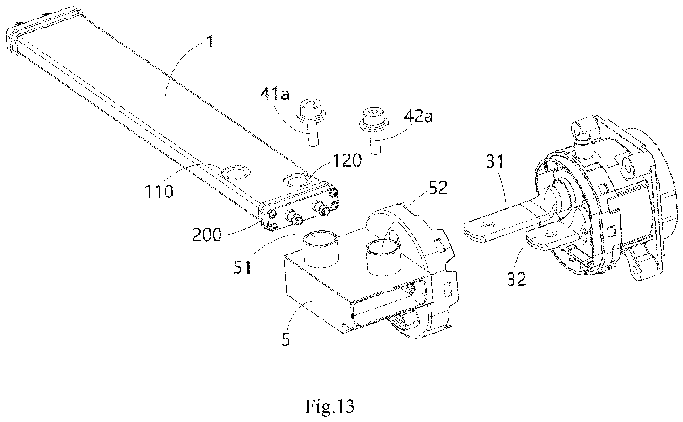

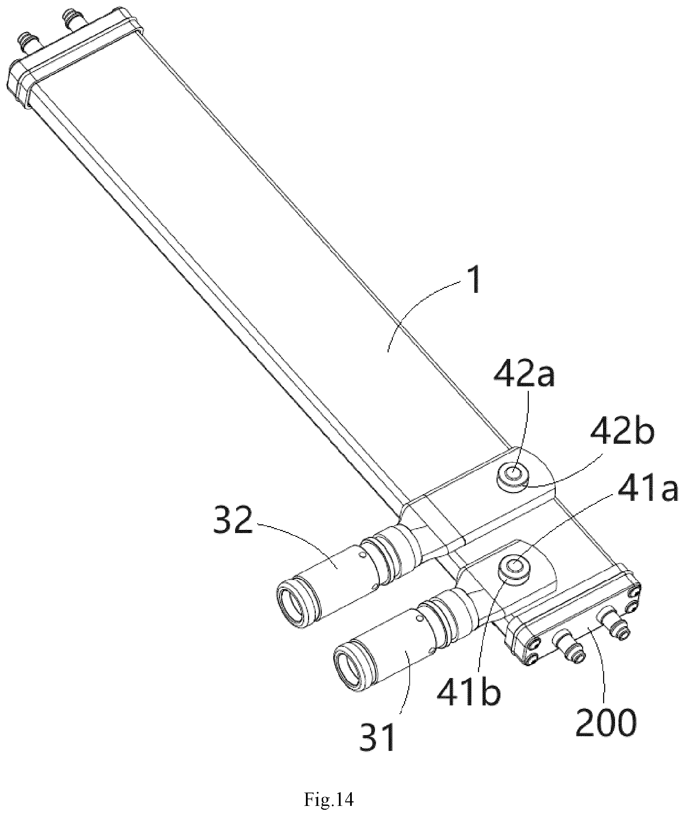

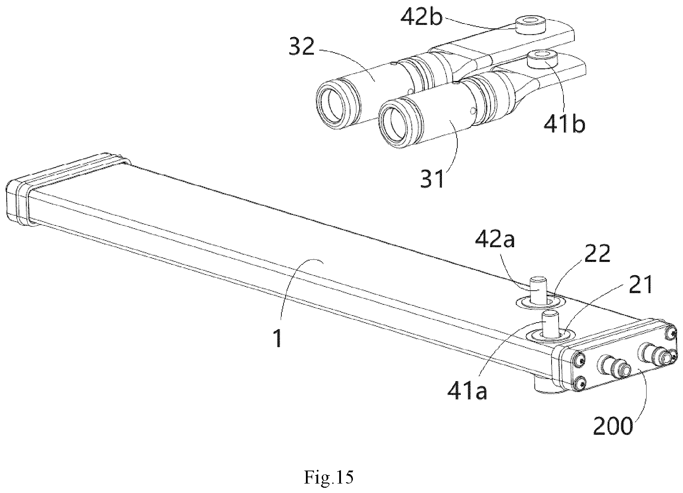

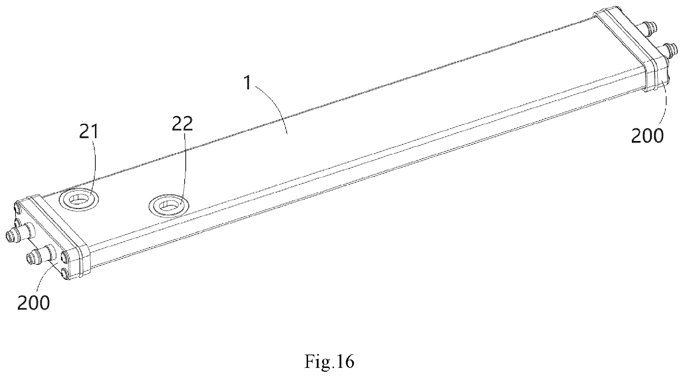

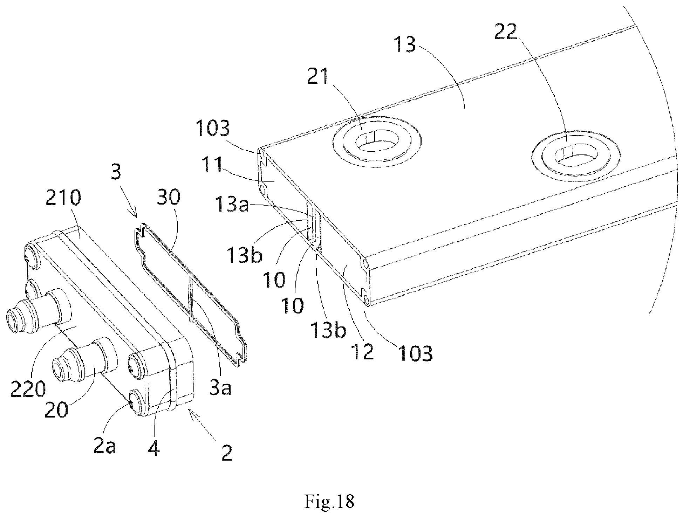

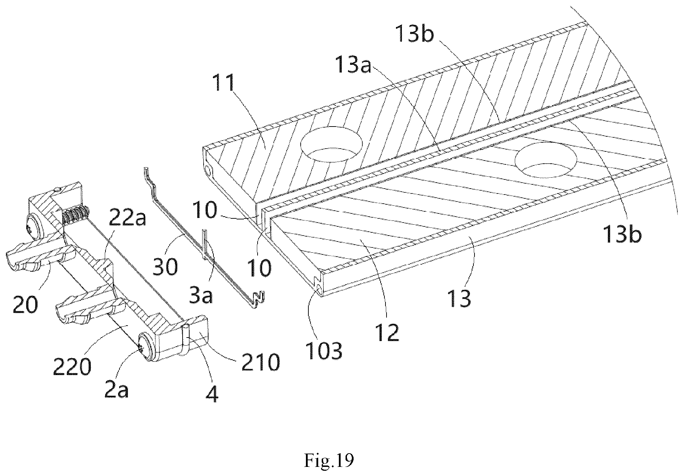

Figure 12 shows an illustrative perspective view of an electrical connection product according to another exemplary embodiment of the present invention, with a fluid adapter module not shown; Figure 13 shows an illustrative exploded view of the electrical connection product shown in Figure 12; Figure 14 shows an illustrative assembled view of a power transmission member 1, a first terminal 31 and a second terminal 32 of the electrical connection product shown in Figure 12; Figure 15 shows an illustrative exploded view of the power transmission member 1, the first terminal 31 and the second terminal 32 of the electrical connection product shown in Figure 12; Figure 16 shows an illustrative perspective view of the power transmission member 1 and an insulating cap assembly 200 of the electrical connection product shown in Figure 12; Figure 17 shows a sectional view of the power transmission member 1 and the insulating cap assembly 200 of the electrical connection product shown in Figure 16; Figure 18 shows an illustrative exploded view of the power transmission member 1 and the insulating cap assembly 200 of the electrical connection product shown in Figure 16; and Figure 19 shows an exploded sectional view of the power transmission member 1 and the insulating cap assembly 200 of the electrical connection product shown in Figure 16.

As shown in Figures 1 to 19, in another exemplary embodiment of the present invention, an electrical connection product is also disclosed. The electrical connection product comprises: a power transmission member 1, an insulating cap assembly 200 and a fluid adapter module 8. The power transmission member 1 comprises an insulating body 13 and a first metal busbar 11 and a second metal busbar 12 wrapped in the insulating body 13, and a cooling passage 10 is formed in the insulating body 13. The insulating cap assembly 200 comprises an insulating cap 2 sealingly sleeved on an end portion of the power transmission member 1, and a pipe connector 20 is formed on the insulating cap 2. The first mating connector 81 of the fluid adapter module 8 is in mating connection with the pipe connector 20. The second mating connector 82 of the fluid adapter module 8 is configured for mating connection with a connecting pipe of a cooling circuit to allow a cooling fluid to flow between the cooling passage 10 of the power transmission member 1 and the cooling circuit via the fluid adapter module 8.

As shown in Figures 1 to 19, in the illustrated embodiment, two cooling passages 10 are formed in the insulating body 13, and the insulating body 13 has an intermediate partition wall 13a for separating the two cooling passages 10. The two cooling passages 10 are respectively adjacent to the first metal busbar 11 and the second metal busbar 12, to enable the first metal busbar 11 and the second metal busbar 12 to be cooled respectively by the cooling fluid flowing through the two cooling passages 10.

As shown in Figures 1 to 19, in the illustrated embodiment, the insulating body 13 has isolation walls 13b for isolating the cooling passages 10 from the first metal busbar 11 and the second metal busbar 12, to enable the cooling fluid flowing through the cooling passages 10 not to be in physical contact with the first metal busbar 11 and the second metal busbar 12.

As shown in Figures 1 to 19, in the illustrated embodiment, the insulating body 13 is an injection-molded member formed directly on the first metal busbar 11 and the second metal busbar 12 by means of an insert injection molding process, such that the first metal busbar 11, the second metal busbar 12 and the insulating body 13 are formed to be an integral part.

As shown in Figures 1 to 19, in the illustrated embodiment, the insulating cap 2 comprises: a peripheral wall 210 and an end wall 220. The peripheral wall 210 is sleeved on the end portion of the power transmission member 1. The end wall 220 is connected to the peripheral wall 210. The pipe connector 20 is formed on the end wall 220, a threaded hole 103 is formed in an end surface of the insulating body 13, and a connecting hole corresponding to the threaded hole 103 is formed in the end wall 220. The insulating cap assembly 200 further comprises a threaded member 2a configured to pass through the connecting hole and be threadedly connected to the threaded hole 103 to secure the insulating cap 2 to the end portion of the power transmission member 1.

As shown in Figures 1 to 19, in the illustrated embodiment, the insulating cap assembly 200 further comprises a sealing member 3 and the sealing member 3 comprises an annular body 30 squeezed between the end wall 220 of the insulating cap 2 and an end surface of the power transmission member 1 to achieve sealing between the insulating cap and the power transmission member. The connecting hole and the threaded hole 103 are located outside a region surrounded by the annular body 30 of the sealing member 3, and the pipe connector 20 and end openings of the cooling passage 10 of the power transmission member 1 are located inside the region surrounded by the annular body 30 of the sealing member 3.

As shown in Figures 1 to 19, in the illustrated embodiment, the first metal busbar 11 and the second metal busbar 12 each have a top surface and a bottom surface opposite each other in a thickness direction thereof and two side surfaces opposite each other in a width direction thereof. The first metal busbar 11 and the second metal busbar 12 are arranged side by side and spaced oppositely in the width direction thereof, and the cooling passages 10 are located between the side surface of the first metal busbar 11 and the side surface of the second metal busbar 12.

As shown in Figures 1 to 19, in the illustrated embodiment, the insulating cap 2 has two pipe connectors 20, and the two pipe connectors 20 are connected with the two cooling passages 10 of the power transmission member 1 respectively and are connected to two first mating connectors 81 of the fluid adapter module 8 respectively, to enable the cooling fluid to flow into and out of the two cooling passages 10 respectively through the two pipe connectors 20.

As shown in Figures 1 to 19, in the illustrated embodiment, the insulating cap 2 further has a partition rib 22a formed on an inner side of the end wall 22, and the sealing member 3 further has an isolation rib 3a located in the annular body 30 and connected to the annular body 30. The isolation rib 3a of the sealing member 3 is squeezed between the partition rib 22a of the insulating cap 2 and an end surface of the intermediate partition wall 13a of the insulating body 13, to isolate end openings of the two fluid passages 10 from each other and isolate the two pipe connectors 20 from each other.

As shown in Figures 1 to 19, in the illustrated embodiment, the electrical connection product further comprises: a housing 5, a first terminal 31 and a second terminal 32. The first terminal 31 and the second terminal 32 are inserted and mounted into the housing 5. The first metal busbar 11 and the second metal busbar 12 are electrically connected to the first terminal 31 and the second terminal 32, respectively. The insulating cap 2 is inserted and mounted into the housing 5, and the pipe connector 20 of the insulating cap 2 is exposed from the housing 5 for mating connection with the first mating connector 81.

As shown in Figures 1 to 19, in the illustrated embodiment, the insulating cap assembly 200 further comprises an outer sealing ring 4 sleeved on the insulating cap 2. The outer sealing ring 4 is squeezed radially between the insulating cap 2 and the housing 5 to achieve sealing between the insulating cap and the housing.

As shown in Figures 12 to 19, in another exemplary embodiment of the present invention, an electrical connection product is also disclosed. The electrical connection product comprises: a housing 5, a first terminal 31, a second terminal 32, and a power transmission member 1. The first terminal 31 and the second terminal 32 are inserted and mounted into the housing 5. The power transmission member 1 comprises an insulating body 13 and a first metal busbar 11 and a second metal busbar 12 wrapped in the insulating body 13 and electrically isolated by the insulator 13. The first metal busbar 11 has a first connecting end 110 electrically connected to the first terminal 31, and the second metal busbar 12 has a second connecting end 120 electrically connected to the second terminal 32, and the first connecting end 110 and the second connecting end 120 are wrapped in the insulating body 13 and do not protrude from the insulating body 13.

As shown in Figures 12 to 19, in the illustrated embodiment, the first terminal 31 and the second terminal 32 extend in the longitudinal direction Y of the housing 5, and the power transmission member 1 extends in the transverse direction X of the housing 5, such that the extension direction of the power transmission member 1 is perpendicular to the extension direction of the first terminal 31 and the second terminal 32.

As shown in Figures 12 to 19, in the illustrated embodiment, a rear end of the first terminal 31 and a rear end of the second terminal 32 are offset from each other by a first distance and a second distance in the longitudinal direction Y and the transverse direction X of the housing 5, respectively. The first connecting end 110 and the second connecting end 120 are offset from each other by the first distance and the second distance in the longitudinal direction Y and the transverse direction X of the housing 5, respectively. The rear end of the first terminal 31 is electrically connected to the first connecting end 110, and the rear end of the second terminal 32 is electrically connected to the first connecting end 110.

As shown in Figures 12 to 19, in the illustrated embodiment, the power transmission member 1 is flat in shape, and the first metal busbar 11 and the second metal busbar 12 are flat aluminum busbars or flat copper busbars.

As shown in Figures 12 to 19, in the illustrated embodiment, the first metal busbar 11 and the second metal busbar 12 are arranged side by side in the width direction of the power transmission member 1.

As shown in Figures 12 to 19, in the illustrated embodiment, the electrical connection product further comprises: a first conductive component 21 and a second conductive component 22. The first conductive component 21 is electrically connected between the first connecting end 110 of first metal busbar 11 and the rear end of the first terminal 31. The second conductive component 22 is electrically connected between the second connecting end 120 of the second metal busbar 12 and the rear end of second terminal 32. In the illustrated embodiment, the first conductive component 21, the second conductive component 22, the first terminal 31, and the second terminal 32 may be made of copper, and the first metal busbar 11 and the second metal busbar 12 may be made of aluminum.

As shown in Figures 12 to 19, in the illustrated embodiment, the first conductive component 21 is tubular, one end of the first conductive component 21 is welded to the first connecting end 110 of the first metal busbar 11, and the other end of the first conductive component 21 protrudes from the insulating body 13 for electrical contact with the first terminal 31.

As shown in Figures 12 to 19, in the illustrated embodiment, the electrical connection product further comprises: a first nut 41b and a first bolt 41a. The first nut 41b is secured to the rear end of first terminal 31. The first bolt 41a passes through the first conductive component 21 and the first terminal 31 and is threadedly connected to the first nut 41b to secure the first conductive component 21 to the first terminal 31.

As shown in Figures 12 to 19, in the illustrated embodiment, the second conductive component 22 is tubular, one end of the second conductive component 22 is welded to the second connecting end 120 of the second metal busbar 12, and the other end of the second conductive component 22 protrudes from the insulating body 13 for electrical contact with the second terminal 32.

As shown in Figures 12 to 19, in the illustrated embodiment, the electrical connection product further comprises: a second nut 42b and a second bolt 42a. The second nut 42b is secured to the rear end of second terminal 32. The second bolt 42a passes through the second conductive component 22 and the second terminal 32 and is threadedly connected to the second nut 42b to secure the second conductive component 22 to the second terminal 32.

As shown in Figures 12 to 19, in the illustrated embodiment, the housing 5 has two sides opposite each other in the transverse direction X thereof and top and bottom sides opposite each other in the height direction Z thereof, an insertion port is formed on one side in the transverse direction X of the housing 5, and a first mounting hole 51 and a second mounting hole 52 are formed on the top side or the bottom side of the housing 5. The end portion of the power transmission member 1 and the first conductive component 21 and the second conductive component 22 are inserted into the housing 5 through the insertion port, and the first bolt 41a and the second bolt 42a are inserted into the housing 5 through the first mounting hole 51 and the second mounting hole 52, respectively.

As shown in Figures 12 to 19, in the illustrated embodiment, the electrical connection product is a charging dock adapted to mate with a charging gun, and the first terminal 31 and second terminal 32 are charging terminals of the charging dock.

As shown in Figures 12 to 19, in the illustrated embodiment, a cooling passage 10 is formed in the insulating body 13, and the cooling passage 10 is located between the first metal busbar 11 and the second metal busbar 12, to enable the first metal busbar 11 and the second metal busbar 12 to be cooled by the cooling fluid flowing through the cooling passage 10.

As shown in Figures 12 to 19, in the illustrated embodiment, two cooling passages 10 are formed in the insulating body 13, and the insulating body 13 has an intermediate partition wall 13a for separating the two cooling passages 10. The two cooling passages 10 are respectively adjacent to the first metal busbar 11 and the second metal busbar 12, to enable the first metal busbar 11 and the second metal busbar 12 to be cooled respectively by the cooling fluid flowing through the two cooling passages 10.

However, the present invention is not limited to the illustrated embodiment. For example, in another exemplary embodiment of the present invention, a single cooling passage 10 may be formed in the insulating body 13, to enable the first metal busbar 11 and the second metal busbar 12 to be cooled simultaneously by the cooling fluid flowing through the single cooling passage 10.

As shown in Figures 12 to 19, in the illustrated embodiment, the insulating body 13 has isolation walls 13b for isolating the cooling passages 10 from the first metal busbar 11 and the second metal busbar 12, to enable the cooling fluid flowing through the cooling passages 10 not to be in physical contact with the first metal busbar 11 and the second metal busbar 12.

As shown in Figures 12 to 19, in the illustrated embodiment, the insulating body 13 is an injection-molded member formed directly on the first metal busbar 11 and the second metal busbar 12 by means of an insert injection molding process, such that the first metal busbar 11, the second metal busbar 12 and the insulating body 13 are formed to be an integral part.

As shown in Figures 12 to 19, in the illustrated embodiment, the electrical connection product further comprises an insulating cap assembly 200. The insulating cap assembly 200 comprises an insulating cap 2 sealingly sleeved on the end portion of the power transmission member 1. A pipe connector 20 is formed on the insulating cap 2 and is configured to be connected to a connecting pipe (not shown) of a cooling circuit. The pipe connector 20 is connected to an end opening of the fluid passage 10 of the power transmission member 1, to allow the cooling fluid to flow into and out of the cooling passage 10 of the power transmission member 1 via the pipe connector 20.

As shown in Figures 12 to 19, in the illustrated embodiment, the insulating cap 2 comprises: a peripheral wall 210 and an end wall 220. The peripheral wall 210 is sleeved on the end portion of the power transmission member 1. The end wall 220 is connected to the peripheral wall 210. The pipe connector 20 is formed on the end wall 220, a threaded hole 103 is formed in an end surface of the insulating body 13, and a connecting hole corresponding to the threaded hole 103 is formed in the end wall 220. The insulating cap assembly 200 further comprises a threaded member 2a configured to pass through the connecting hole and be threadedly connected to the threaded hole 103 to secure the insulating cap 2 to the end portion of the power transmission member 1.

As shown in Figures 12 to 19, in the illustrated embodiment, the insulating cap assembly 200 further comprises a sealing member 3 and the sealing member 3 comprises an annular body 30 squeezed between the end wall 220 of the insulating cap 2 and an end surface of the power transmission member 1 to achieve sealing between the insulating cap and the power transmission member. The connecting hole and the threaded hole 103 are located outside a region surrounded by the annular body 30 of the sealing member 3, and the pipe connector 20 and the end opening of the cooling passage 10 of the power transmission member 1 are located inside the region surrounded by the annular body 30 of the sealing member 3.

As shown in Figures 12 to 19, in the illustrated embodiment, the first metal busbar 11 and the second metal busbar 12 each have a top surface and a bottom surface opposite each other in a thickness direction thereof and two side surfaces opposite each other in a width direction thereof. The first metal busbar 11 and the second metal busbar 12 are arranged side by side and spaced oppositely in the width direction thereof, and the cooling passage 10 is located between the side surface of the first metal busbar 11 and the side surface of the second metal busbar 12.

As shown in Figures 12 to 19, in the illustrated embodiment, two cooling passages 10 are formed in the insulating body 13, and the insulating body 13 has an intermediate partition wall 13a for separating the two cooling passages 10 and isolation walls 13b for isolating the cooling passages 10 from the first metal busbar 11 and the second metal busbar 12.

As shown in Figures 12 to 19, in the illustrated embodiment, the insulating cap 2 has two pipe connectors 20, and the two pipe connectors 20 are connected with end openings of the two cooling passages 10 of the power transmission member 1 respectively, to enable the cooling fluid to flow into and out of the two cooling passages 10 respectively through the two pipe connectors 20.

As shown in Figures 12 to 19, in the illustrated embodiment, the insulating cap 2 further has a partition rib 22a formed on an inner side of the end wall 22, and the sealing member 3 further has an isolation rib 3a located in the annular body 30 and connected to the annular body 30. The isolation rib 3a of the sealing member 3 is squeezed between the partition rib 22a of the insulating cap 2 and an end surface of the intermediate partition wall 13a of the insulating body 13, to isolate end openings of the two fluid passages 10 from each other and isolate the two pipe connectors 20 from each other.

As shown in Figures 12 to 19, in the illustrated embodiment, the insulating cap 2 is inserted and mounted into the housing 5, and the pipe connector 20 of the insulating cap 2 is exposed from the housing 5 for connection with the connecting pipe of the cooling circuit. The insulating cap assembly 200 further comprises an outer sealing ring 4 sleeved on the peripheral wall 210 of the insulating cap 2. The outer sealing ring 4 is squeezed radially between the insulating cap 2 and the housing 5 to achieve sealing between the insulating cap and the housing.

As shown in Figures 12 to 19, in the illustrated embodiment, the power transmission member 1 has the cooling passage 10 located between the first metal busbar 11 and the second metal busbar 12, such that the first metal busbar 11 and the second metal busbar 12 can be fully cooled by the cooling fluid flowing through the cooling passage 10. The cooling passage 10 of the present invention has a large cooling area and a high cooling efficiency, can effectively reduce the temperature rise of the power transmission member without increasing the cross-sectional area of the metal busbars.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A fluid adapter module, comprising:
a housing (80) comprising:
a housing body (810) defining an inner cavity (803) for accommodating a cooling fluid;
a first mating connector (81) formed on an outer side of the housing body (810) and connected with the inner cavity (803); and
a second mating connector (82) formed on the outer side of the housing body (810) and connected with the inner cavity (803);
wherein the first mating connector (81) is configured for mating connection with a pipe connector (20) on an insulating cap (2) of a power transmission member (1) and the second mating connector (82) is configured for mating connection with a connecting pipe of a cooling circuit, such that a cooling passage (10) in the power transmission member (1) is capable of being connected to the cooling circuit via the fluid adapter module (8).

2. The fluid adapter module according to claim 1, wherein the housing body (810) is configured to define two inner cavities (803) spaced apart from each other, the housing (80) comprises two first mating connectors (81) connected with the two inner cavities (803), respectively, and the two first mating connectors (81) are configured for respectively mating connection with two pipe connectors (20) on the insulating cap (2) of the power transmission member (1), and
wherein the housing (80) comprises two second mating connectors (82) connected with the two inner cavities (803), respectively, the two second mating connectors (82) being configured for mating connection with two connecting pipes of the cooling circuit, respectively.

3. The fluid adapter module according to claim 1, wherein the first mating connector (81) is formed on an outer side of a rear wall of the housing body (810), the second mating connector (82) is formed on a bottom wall of the housing body (810), and the housing body (810) has a front opening opposite the rear wall of the housing body; and
wherein the housing (80) further comprises:
a front cover (83) mounted on the front opening of the housing body (810) to close the front opening of the housing body (810).

4. The fluid adapter module according to claim 3, further comprising:
a screw (85) passing through the front cover (83) and being threadedly connected to a front side of the housing body (810) to secure the front cover (83) to the front side of the housing body (810); and
a sealing ring (86) squeezed between the front cover (83) and the housing body (810) to achieve sealing between the front cover and the housing body.

5. The fluid adapter module according to claim 1, further comprising:
a locking member inserted and mounted in the first mating connector (81) and configured to lock the pipe connector (20) in the first mating connector (81);
wherein the locking member is movable between a locking position in which the locking member is engaged with the pipe connector (20) and an unlocking position in which the locking member is disengaged from the pipe connector (20) in an axial direction of the first mating connector (81).

6. The fluid adapter module according to claim 5, further comprising:
an unlocking member (84) mounted on the housing body (810) and movable in a radial direction of the first mating connector (81);
wherein an inclined surface (84b) axially inclined to the first mating connector (81) is formed on the unlocking member (84), and the inclined surface (84b) is configured to convert a radial movement of the unlocking member (84) into an axial movement of the locking member, to enable the locking member to be axially pushed from the locking position to the unlocking position by the unlocking member (84),wherein the unlocking member (84) is movable between a first position and a second position in the radial direction of the first mating connector (81);
wherein when the unlocking member (84) is moved to the first position, the unlocking member (84) axially pushes the locking member to the unlocking position by means of the inclined surface (84b) on the unlocking member; and
wherein when the unlocking member (84) is moved to the second position, the unlocking member (84) is disengaged from the locking member, and the locking member is elastically reset to the locking position automatically.

7. The fluid adapter module according to claim 6, wherein
the housing body (810) has a mounting portion (820) located on the outer side of the housing body, the mounting portion (820) has a bottom plate (822) and a pair of side plates (821), the first mating connector (81) is located in the mounting portion (820), and the unlocking member (84) is movably mounted on the mounting portion (820) and is movable between the first position and the second position in a vertical direction.

8. The fluid adapter module according to claim 7, wherein
insertion slots (82b) extending in the vertical direction are formed in inner sides of the pair of side plates (821) of the mounting portion (820), and two sides of the unlocking member (84) are respectively inserted and mounted into the insertion slots (82b) of the pair of side plates (821) and the unlocking member (84) is movable between the first position and the second position along the insertion slots (82b).

9. The fluid adapter module according to claim 8, wherein a slot hole (82a) is formed in the bottom plate (822) of the mounting portion (820), the unlocking member (84) has an elastic latch (840) configured to pass through the slot hole (82a), and a first protruding rib (841) and a second protruding rib (842) below the first protruding rib (841) are formed on the elastic latch (840);
wherein when the unlocking member (84) is moved to the first position, the first protruding rib (841) abuts against a lower edge portion of the slot hole (82a) to retain the unlocking member (84) in the first position; and
wherein when the unlocking member (84) is moved to the second position, the second protruding rib (842) abuts against an upper edge portion of the slot hole (82a) to retain the unlocking member (84) in the second position.

10. The fluid adapter module according to claim 9, wherein when the unlocking member (84) is moved to a pre-assembly position between the first position and the second position, the first protruding rib (841) abuts against the upper edge portion of the slot hole (82a) to retain the unlocking member (84) in the pre-assembly position; and
wherein when the unlocking member (84) is in the pre-assembly position, the unlocking member (84) does not interfere with the locking member and the pipe connector (20) to allow the pipe connector (20) to be inserted into the first mating connector (81).

11. An electrical connection product, comprising:
a power transmission member (1) comprising an insulating body (13) and a first metal busbar (11) and a second metal busbar (12) wrapped in the insulating body (13), a cooling passage (10) being formed in the insulating body (13);
an insulating cap assembly (200) comprising an insulating cap (2) sealingly sleeved on an end portion of the power transmission member (1), a pipe connector (20) being formed on the insulating cap (2); and
a fluid adapter module according to any one of claims 1-10, a first mating connector (81) of the fluid adapter module being in mating connection with the pipe connector (20),
wherein a second mating connector (82) of the fluid adapter module (8) is configured for mating connection with a connecting pipe of a cooling circuit to allow a cooling fluid to flow between the cooling passage (10) of the power transmission member (1) and the cooling circuit via the fluid adapter module (8).

12. The electrical connection product according to claim 11, wherein two cooling passages (10) are formed in the insulating body (13), and the insulating body (13) has an intermediate partition wall (13a) for separating the two cooling passages (10);
wherein the two cooling passages (10) are respectively adjacent to the first metal busbar (11) and the second metal busbar (12), to enable the first metal busbar (11) and the second metal busbar (12) to be cooled respectively by the cooling fluid flowing through the two cooling passages (10); and wherein
the insulating body (13) has isolation walls (13b) for isolating the cooling passages (10) from the first metal busbar (11) and the second metal busbar (12), to enable the cooling fluid flowing through the cooling passages (10) not to be in physical contact with the first metal busbar (11) and the second metal busbar (12).

13. The electrical connection product according to claim 12, wherein the insulating cap (2) comprises:
a peripheral wall (210) sleeved on the end portion of the power transmission member (1); and
an end wall (220) connected to the peripheral wall (210);
wherein the pipe connector (20) is formed on the end wall (220), a threaded hole (103) is formed in an end surface of the insulating body (13), and a connecting hole corresponding to the threaded hole (103) is formed in the end wall (220); and
wherein the insulating cap assembly (200) further comprises a threaded member (2a) configured to pass through the connecting hole and be threadedly connected to the threaded hole (103) to secure the insulating cap (2) to the end portion of the power transmission member (1).

14. The electrical connection product according to claim 13, wherein the insulating cap assembly (200) further comprises:
a sealing member (3) comprising an annular body (30) squeezed between the end wall (220) of the insulating cap (2) and an end surface of the power transmission member (1) to achieve sealing between the insulating cap and the power transmission member;
wherein the connecting hole and the threaded hole (103) are located outside a region surrounded by the annular body (30) of the sealing member (3), and the pipe connector (20) and end openings of the cooling passage (10) of the power transmission member (1) are located inside the region surrounded by the annular body (30) of the sealing member (3).

15. The electrical connection product according to claim 12, wherein the insulating cap (2) has two pipe connectors (20), and the two pipe connectors (20) are connected with the two cooling passages (10) of the power transmission member (1) respectively and are connected to two first mating connectors (81) of the fluid adapter module (8) respectively, to enable the cooling fluid to flow into and out of the two cooling passages (10) respectively through the two pipe connectors (20), wherein the insulating cap (2) further has a partition rib (22a) formed on an inner side of the end wall (22), and the sealing member (3) further has an isolation rib (3a) located in the annular body (30) and connected to the annular body (30); and
wherein the isolation rib (3a) of the sealing member (3) is squeezed between the partition rib (22a) of the insulating cap (2) and an end surface of the intermediate partition wall (13a) of the insulating body (13), to isolate end openings of the two fluid passages (10) from each other and isolate the two pipe connectors (20) from each other.
